(19) **Europäisches Patentamt / European Patent Office / Office européen des brevets**

(11) **EP 3 048 451 A1**

(12) # EUROPEAN PATENT APPLICATION

(43) Date of publication:
**27.07.2016 Bulletin 2016/30**

(51) Int Cl.:
***G01R 31/36*** *(2006.01)*

(21) Application number: **15193812.3**

(22) Date of filing: **10.11.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **21.01.2015 KR 20150010058**

(71) Applicant: **Samsung Electronics Co., Ltd Gyeonggi-do 443-742 (KR)**

(72) Inventors:
• YOU, Kaeweon
  **443-803 Gyeonggi-do (KR)**
• PARK, SangDo
  **443-803 Gyeonggi-do (KR)**

(74) Representative: **Grünecker Patent- und Rechtsanwälte PartG mbB Leopoldstraße 4 80802 München (DE)**

(54) **METHOD AND APPARATUS FOR ESTIMATING THE STATE OF A BATTERY**

(57)  A method and apparatus for estimating a state of a battery are provided. A battery life estimation apparatus may acquire sensing data of a battery, may extract a stress pattern from the sensing data that represents changes in states of the battery based on stress applied to the battery, and may estimate a life of the battery based on the stress pattern.

**FIG. 12**

EP 3 048 451 A1

**Description**

1. Field

The following description relates to a method and apparatus estimating a state of a battery.

2. Description of Related Art

As environmental concerns and energy resource issues become more important, an electric vehicle (EV) has been highlighted as a vehicle of the future. The EV may not emit exhaust fumes, and may produce less noise, than a gasoline based vehicle. In such an EV, a battery may be formed in a single pack with a plurality of rechargeable and dischargeable secondary cells and even used as a main power source for the EV.

Thus, in such an EV, the battery may operate as a fuel tank would for an engine of a gasoline powered vehicle. Thus, to enhance a safety of a user of the EV, checking a state of the battery may be important.

Recently, research is being conducted to increase a convenience of a user while more accurately monitoring a state of a battery.

SUMMARY

This Summary is provided to introduce a selection of concepts in a simplified form that are further described below in the Detailed Description. This Summary is not intended to identify key features or essential features of the claimed subject matter, nor is the Summary intended to be used as an aid in determining the scope of the claimed subject matter.

One or more embodiments provide a battery life estimation apparatus including a stress pattern extractor configured to use at least one processing device to extract a stress pattern from sensing data acquired for a battery, the stress pattern representing changes in states of the battery based on stresses applied to the battery and characterized by categorizing different stresses represented in the sensing data, and a life estimator configured to use at least one processing device to estimate a life of the battery based on the characterized stress pattern.

The apparatus may further include a sensor system including a plurality of sensors to measure the sensing data of the battery, the sensing data being real time measurements of physical properties of the battery.

The life estimator may estimate the life of the battery in real time by providing characteristic data, as the categorized different stresses, to a learner to which a learning parameter is applied, wherein the learning parameter is previously trained on battery training sensing data of a previous time.

The sensing data may include at least one of voltage data, current data, and temperature data of the battery sensed from respective sensors configured to measure corresponding properties of the battery.

The stress pattern extractor may be configured to extract the stress pattern from the sensing data using a rainflow counting scheme, and the stress pattern may represent a plurality of cycles that respectively represent changes in values of the sensing data over time.

The stress pattern extractor may be configured to perform the categorizing by extracting a level for each of the plurality of cycles from a plurality of levels of a determined parameter, and configured to generate, based on each of the levels, characteristic data representing a characteristic of the stress pattern.

The stress pattern extractor may be configured to perform the categorizing by generating the characteristic data based on a determined number of cycles, of the plurality of cycles, that correspond to each of the plurality of levels.

The determined parameter may include at least one of an offset, an amplitude, and a period of each of the plurality of cycles.

The stress pattern extractor may be configured to create a plurality of combination parameters, each representing respective levels for each of a plurality of the determined parameters for a cycle, and configured to perform the categorizing by generating the characteristic data based on a determined number of cycles, of the plurality of cycles, whose determined parameters correspond to each of the plurality of combination parameters.

The stress pattern extractor may be configured to determine the number of cycles by applying different weights to different cycle patterns of the plurality of cycles. The different cycle patterns may include full and half cycle patterns.

The apparatus may further include a dimension transformer configured to reduce a dimension of the characteristic data, wherein the life estimator is configured to estimate the life of the battery by inputting the characteristic data with the reduced dimension to a predetermined learner to which a predetermined learning parameter is applied.

The stress pattern extractor may be configured to generate the characteristic data at a predetermined period, so that characteristic data is generated for plural predetermined periods.

The life estimator may be configured to estimate the life of the battery by inputting the characteristic data to a predetermined learner to which a predetermined learning parameter is applied.

The apparatus may include a communication interface, wherein the life estimator is configured to receive the predetermined learning parameter from an external apparatus using the communication interface, and configured to apply the received learning parameter to the predetermined learner.

The apparatus may include a storage configured to store in advance the predetermined learning parameter, wherein the life estimator is configured to obtain the predetermined learning parameter from the storage and apply the obtained predetermined learning parameter to the predetermined learner.

The life estimator may estimate the life of the battery in real time by providing characteristic data, as the categorized different stresses, to a learner to which a learning parameter is applied, and wherein the learning parameter is trained on battery training sensing data of a previous time, where the life estimation apparatus may further include a training data acquirer configured to acquire the battery training sensing data for the battery, in the previous time, a training stress pattern extractor configured to use at least one processing device to extract a training stress pattern from the battery training sensing data, the training stress pattern representing changes in states of the battery based on stresses applied to the battery and characterized by categorizing different stresses represented in the training data, and a learning parameter determiner configured to use at least one processing device to determine the learning parameter based on the characterized training stress pattern.

One or more embodiments provide a battery life estimation apparatus including a training stress pattern extractor configured to use at least one processing device to extract a training stress pattern from training data for a battery, the training stress pattern representing change in states of the battery based on stresses applied to the battery and characterized by categorizing different stresses represented in the training data, and a learning parameter determiner configured to use at least one processing device to determine a learning parameter based on the characterized training stress pattern, the learning parameter being determined for use in estimating a life of the battery.

The training data may be derived from a previous measuring of physical properties of the battery.

The training stress pattern extractor may be configured to extract the training stress pattern from the training data using a rainflow counting scheme, and the training stress pattern may represent a plurality of cycles that respectively represent changes in values of the training data over time.

The training stress pattern extractor may be configured to perform the categorizing by extracting a level for each of the plurality of cycles from a plurality of levels of a determined parameter, and configured to generate characteristic data based on a determined number of cycles, of the plurality of cycles, that correspond to each of the plurality of levels, so that the characteristic data represents a characteristic of the training stress pattern.

The determined parameter may include at least one of an offset, an amplitude, and a period of each of the plurality of cycles.

The training stress pattern extractor may be configured to create a plurality of combination parameters, each representing respective levels for each of a plurality of the determined parameters for a cycle, and configured to perform the categorizing by generating the characteristic data based on a determined number of cycles, of the plurality of cycles, whose determined parameters correspond to each of the plurality of combination parameters.

The learning parameter determiner may be configured to extract the learning parameter by inputting the characteristic data to a predetermined learner.

The apparatus may include a communication interface, wherein the learning parameter determiner is configured to transmit the extracted learning parameter to an external apparatus using the communication interface.

The apparatus may include a storage, wherein the learning parameter determiner is configured to store the extracted learning parameter in the storage.

One or more embodiments provide a battery life estimation apparatus including a stress pattern extractor configured to use at least one processing device to generate characterization data that categorizes different stresses of a battery from acquired sensing data of the battery, and a life estimator configured to use at least one processing device to estimate and output a life of the battery based on the characterization data.

One or more embodiments provide a battery life estimation method including acquiring sensing data for physical properties of a battery, extracting, using at least one processing device, a stress pattern from the sensing data, the stress pattern representing changes in states of the battery based on stresses applied to the battery and characterized by categorizing different stresses represented in the sensing data, and estimating a life of the battery based on the categorized stress pattern.

One or more embodiments provide a battery life estimation method including acquiring training data for physical properties for a battery, extracting, using at least one processing device, a training stress pattern from the training data, the training stress pattern representing changes in states of the battery based on stresses applied to the battery and characterized by categorizing different stresses represented by the training data, and determining, using at least one processing device, a learning parameter based on the characterized training stress pattern, the learning parameter being determined for use in estimating a life of the battery.

One or more embodiments provide a non-transitory computer-readable storage medium including computer readable code to cause at least one processing device to perform one or more method embodiments set forth herein.

Other features and aspects will be apparent from the following detailed description, the drawings, and the claims.

BRIEF DESCRIPTION OF THE DRAWINGS

FIG. 1 illustrates an example of charge and discharge (charge/discharge) cycles of a battery.

FIG. 2 illustrates an example of a reduction in a life of a battery due to an increase in a number of use cycles of the battery.

FIG. 3 illustrates example reductions in a life of a battery based on different temperatures at which the battery may be used.

FIG. 4 illustrates example reductions in a life of a battery based on different charge rates (C-rates).

FIG. 5 illustrates example voltage patterns based on a charging and discharging of a battery.

FIGS. 6 through 8 illustrate example reductions in a life of a battery.

FIG. 9 illustrates examples of voltage charging and discharging cycles over time, according to one or more embodiments.

FIG. 10 illustrates an example of a battery life estimation apparatus, according to one or more embodiments.

FIG. 11 illustrates an example of a battery life estimation apparatus, according to one or more embodiments.

FIG. 12 illustrates an example of a battery system, according to one or more embodiments.

FIG. 13 illustrates an example of a stress pattern, according to one or more embodiments.

FIGS. 14A and 14B illustrate an example of characteristic data generation, according to one or more embodiments.

FIG. 15 illustrates an example of characteristic data generation, according to one or more embodiments.

FIG. 16 illustrates an example of a user interface, according to one or more embodiments.

FIG. 17 illustrates an example of a user interface to provide battery life information, according to one or more embodiments.

FIG. 18 illustrates an example of a battery life estimation method, according to one or more embodiments.

FIG. 19 illustrates an example of a battery life estimation method, according to one or more embodiments.

Throughout the drawings and the detailed description, unless otherwise described or provided, the same drawing reference numerals will be understood to refer to the same elements, features, and structures. The drawings may not be to scale, and the relative size, proportions, and depiction of elements in the drawings may be exaggerated for clarity, illustration, and convenience.

DETAILED DESCRIPTION

The following detailed description is provided to assist the reader in gaining a comprehensive understanding of the methods, apparatuses, and/or systems described herein. However, after an understanding of the present disclosure, various changes, modifications, and equivalents of the methods, apparatuses, and/or systems described herein will be apparent to one of ordinary skill in the art. The sequences of operations described herein are merely examples, and are not limited to those set forth herein, but may be changed as will be apparent to one of ordinary skill in the art, with the exception of operations necessarily occurring in a certain order. Also, descriptions of functions and constructions that may be well known to one of ordinary skill in the art may be omitted for increased clarity and conciseness.

The features described herein may be embodied in different forms, and are not to be construed as being limited to the examples described herein.

Various alterations and modifications may be made to the exemplary embodiments, some of which will be illustrated in detail in the drawings and detailed description. However, it should be understood that these embodiments are not construed as limited to the illustrated forms and include all changes, equivalents or alternatives within the idea and the technical scope of this disclosure.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "include" and/or "have," when used in this specification, specify the presence of stated features, integers, steps, operations, elements, components or combinations thereof, but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which this invention belongs, in view of the present disclosure. It will be further understood that terms, such as those defined in commonly used dictionaries, should be interpreted as having a meaning that is consistent with their meaning in the context of the relevant art and the present disclosure and will not be interpreted in an idealized or overly formal sense unless expressly so defined herein.

Hereinafter, exemplary embodiments will be described in detail with reference to the accompanying drawings, wherein like reference numerals refer to like elements throughout. When it is determined a detailed description of a related known function or configuration may make a purpose of an embodiment of the present disclosure unnecessarily ambiguous in describing the embodiment, the detailed description may be omitted herein.

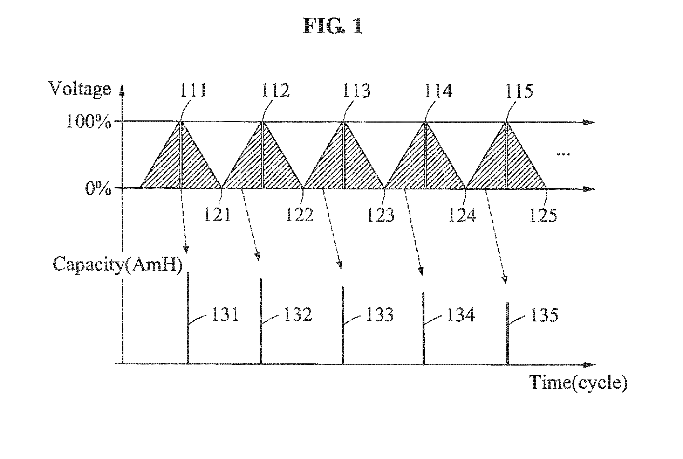

FIG. 1 illustrates an example of charge and discharge (charge/discharge) cycles of a battery.

The top graph of FIG. 1 shows an example of changes in voltage of a battery over time when the battery that is fully charged and discharged. In the top graph, the horizontal axis represents time (or cycles over time) and the vertical axis represents a voltage of the battery. In FIG. 1, at points in time 111, 112, 113, 114, and 115, the battery is fully charged. At points in time 121, 122, 123, 124, and 125, the battery is fully discharged.

As only an example, a single cycle associated with charging and discharging of the battery may indicate a cycle in which power of a fully charged battery is completely discharged and the battery is recharged. For example, a section between the points in time 111 and 112 may be such a single cycle. Here, a "full cycle" may be considered a cycle where the battery is charged, either fully charged or partially charged, from a fully discharged or partially discharged state and where the battery is then discharged, either fully discharged or partially discharged, from that resultant charged state. Similarly, the "full cycle" may be considered a cycle where the battery is discharged, either fully discharged or partially discharged, from a fully charged or partially charged state and where the battery is then charged, either fully charged or partially charged, from that resultant discharged state. Differently, herein, a "half cycle" may be considered a cycle (or portion of a cycle) where the battery is charged, either fully charged or partially charged, from a fully discharged or partially discharged state. Likewise, the "half cycle" may be considered a cycle (or portion of a cycle) where the battery is discharged, either fully discharged or partially discharged, from a fully charged or partially charged state.

The bottom graph of FIG. 1 shows examples of changes in a battery capacity based on repeated full charges and discharges of a battery. In the bottom graph, the horizontal axis represents time (or cycles over time) and the vertical axis represents a capacity of the battery. Lines 131, 132, 133, 134, and 135 represent capacities of the battery corresponding to the points in time 111 through 115. As shown in the bottom graph, as the battery is fully charged and discharged repeatedly over time, the capacity of the battery becomes reduced.

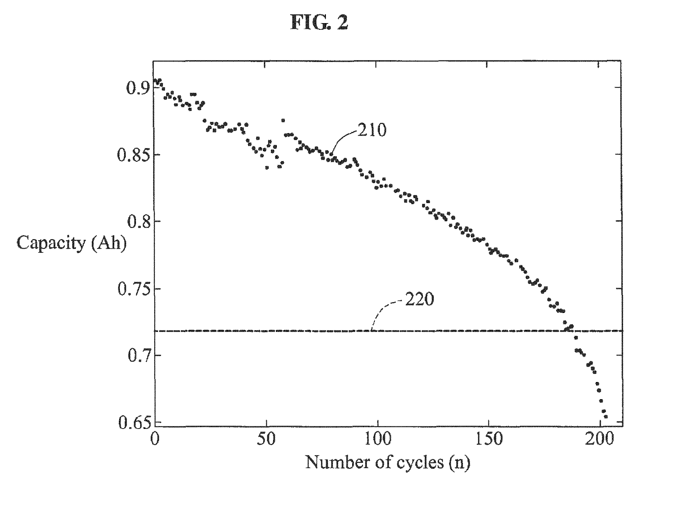

FIG. 2 illustrates an example of a reduction in a life of a battery due to an increase in a number of use cycles of the battery.

Referring to FIG. 2, as the number of cycles in which the battery is charged and discharged increases, the life of the battery is reduced. The life of the battery may refer to a period of time during which the battery normally supplies power, and the like, for an application, i.e., for a physical application, such as to one or more motors or systems of an EV. For example, the life of the battery may correspond to a capacity 210 of the battery as the number of cycles increases. The capacity 210 during the initial cycle(s) may represent a maximum amount of charge to be stored in the battery. When the capacity 210 is reduced below a threshold 220, for example, the battery may be determined to need to be replaced because the battery may not satisfy a power requirement for the particular physical application. Accordingly, the life of the battery may have a high correlation with a period of time during which the battery is used, or the use cycle of the battery.

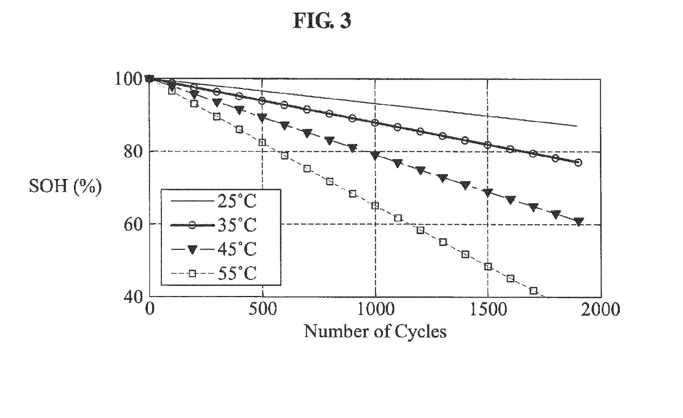

FIG. 3 illustrates example reductions in a life of a battery based on different temperatures at which the battery may be used.

As illustrated in FIG. 3, the life of the battery may be reduced due to changes in temperature, e.g., considering other conditions to be the same, when the battery is charged and discharged. Referring to FIG. 3, typically, the life of the battery operating at a higher temperature, such as 45 or 55°C, is more rapidly reduced. For example, as the number of use cycles of a battery increases, the life of the battery may be more rapidly reduced at 55°C than at 25°C. As only an example, the current life of the battery may be, for example, represented by the term state of health (SOH).

Thus, in the present disclosure, according to one or more embodiments, a battery life may correspond to, for example, a current capacitance value of the battery, an internal resistance value of the battery, or such an SOH of a battery. The SOH may be defined by the below Equation 1, for example.

Equation 1:

$$SOH = \frac{Capacity_{current}}{Capacity_{initial}}$$

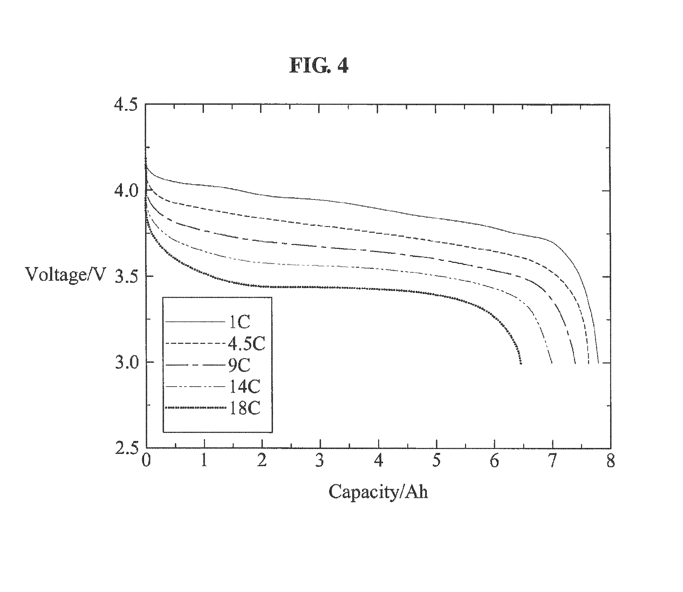

FIG. 4 illustrates example reductions in a life of a battery based on different charge rates (C-rates).

The C-rate may represent a unit of measure used to set a current value, under various use conditions, during charging and discharging of a battery, and may be used to predict or mark a period of time during which a battery is available. The C-rate may be denoted as C, and may be defined by the below Equation 2, for example.

Equation 2:

$$C-rate = \frac{Charge\ and\ discharge\ current}{Battery\ capacity}$$

The graph of FIG. 4 shows an example of a result obtained by performing a life test of a battery for various C-rates,. Referring to FIG. 4, typically, as the C-rate increases, the life of the battery is rapidly reduced. The C-rate may be sensed or determined together with a change in a voltage.

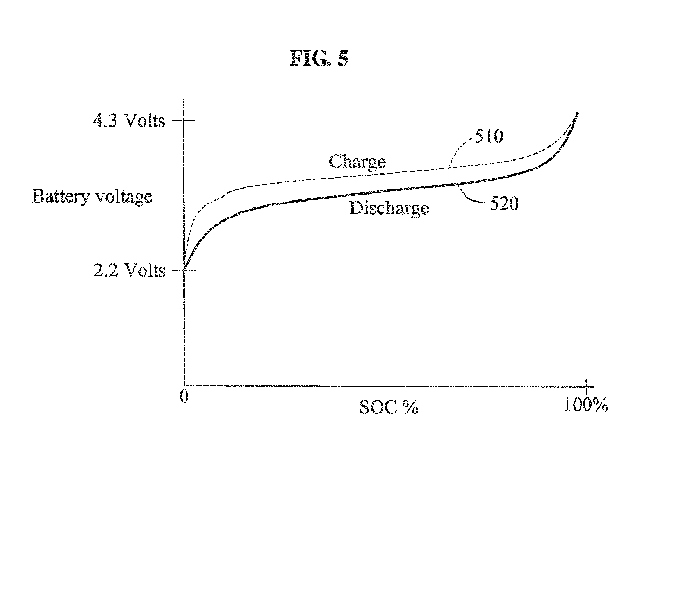

FIG. 5 illustrates example voltage patterns based on a charging and discharging of a battery.

A voltage pattern or a current pattern may change depending on whether the battery is charging or discharging. For example, an influence of the same voltage value or the same current value on a life of the battery may be interpreted to be determined based on whether the battery is being charged or discharged.

In FIG. 5, a voltage pattern 510 occurs based on charging, and a voltage pattern 520 occurs based on discharging. Referring to FIG. 5, different voltage values may be sensed or determined depending on whether the battery is being charged or discharged at the same state of charge (SOC).

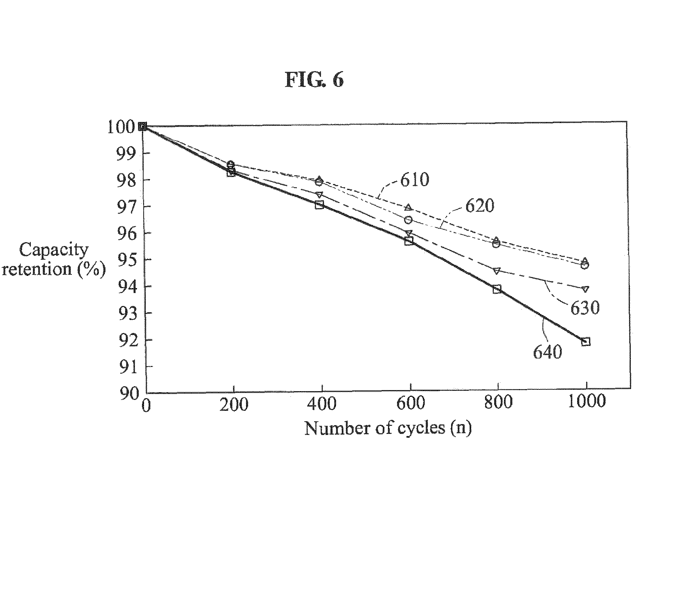

FIGS. 6 through 8 illustrate examples reductions in a life of a battery.

FIG. 6 illustrates an example of a battery life 610 corresponding to a battery voltage range of 50% to 75%, a battery life 620 corresponding to a battery voltage of 25% to 50%, a battery life 630 corresponding to a battery voltage of 0% to 25%, and a battery life 640 corresponding to a battery voltage of 75% to 100%. As illustrated in FIG. 6, an effect of reduction in a life of the battery changes based on voltage ranges of the battery.

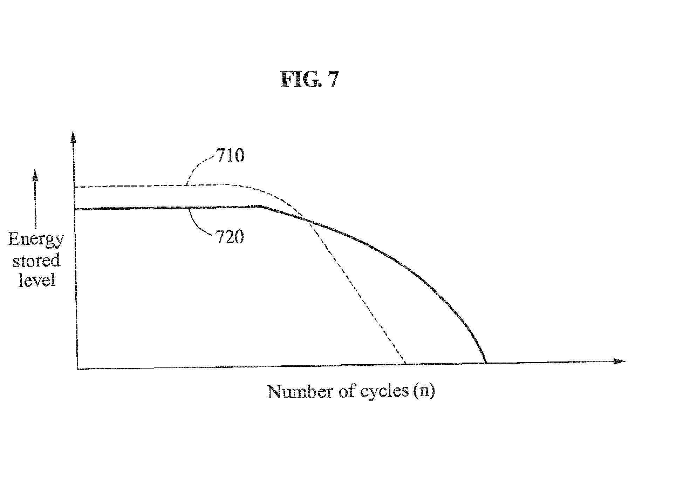

FIG. 7 illustrates an example of an energy stored level 710 based on use of a battery in a fully charged state, and an energy stored level 720 based on use of a battery in an 80 % charged state, demonstrating remaining energy store levels as the number of cycles increase over time. Accordingly, the life of a battery may be reduced less by using the battery in a partially charged state, instead of using the battery in a fully charged state. Said another way, the battery may have a longer life when the battery is used in the partially charged state compared to when the battery is used in the fully charged state.

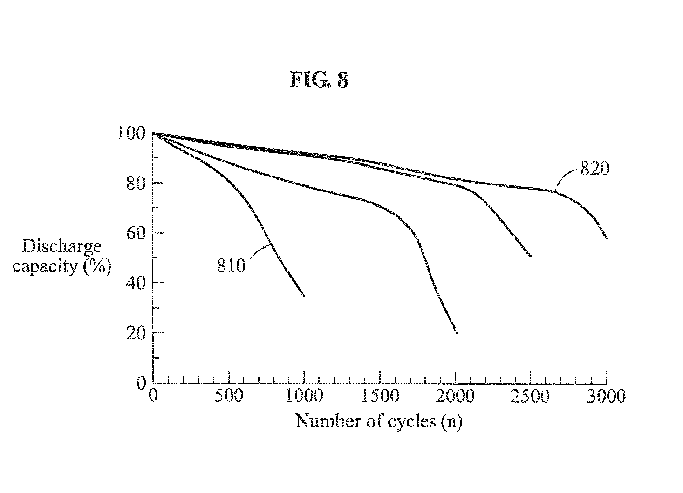

FIG. 8 illustrates an example of a change in a battery life due to a change in a cut-off voltage. The cut-off voltage refers to a voltage at which charging or discharging is terminated. As illustrated in FIG. 8, discharge curves 810 and 820 demonstrate that a discharge capacity reduces at a lower rate when the cut-off voltage is adjusted (as represented by discharge curve 820) than when the cut-off voltage is not adjusted (as represented by discharge curve 810).

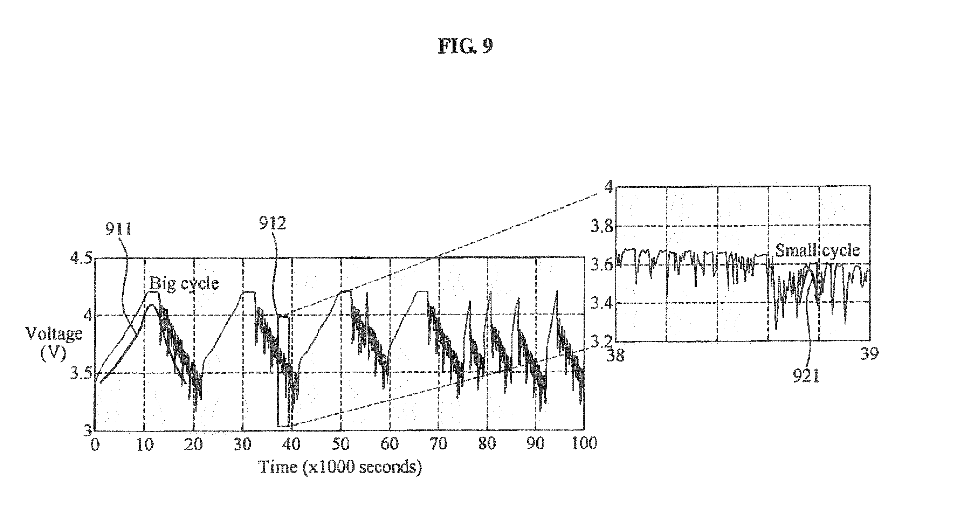

FIG. 9 illustrates examples of voltage charging and discharging cycles over time, according to one or more embodiments.

The left graph of FIG. 9 shows multiple voltage charging and discharging cycles, and the right graph of FIG. 9 shows a zoomed-in view of a section 912 of the left graph. In the right graph and the left graph, the horizontal axis represents time and the vertical axis represents a voltage level.

Stress may be applied to the battery based on charging and discharging of the battery. The stress may represent damage to the battery based on the charging and discharging of the battery. Accordingly, as an amount of stress applied to the battery increases, the life of the battery may decrease.

In the left graph, a voltage of the battery increases during charging of the battery, and decreases during discharging of the battery. When the battery is charged and discharged once, a single voltage full cycle occurs as shown in the left graph. The voltage cycle thus corresponds to a stress pattern that reflects a damage state of the battery.

Various voltage cycles may occur based on a type of charging and/or discharging. In FIG. 9, a representative voltage cycle 911 occurs in response to the battery being charged and discharged over a long period of time, and a representative voltage cycle 921 occurs in response to the battery being charged and discharged over a short period of time. The level of stress applied to the battery may be determined based on the type of voltage cycles. For example, the level of stress applied to the battery based on the voltage cycle 911 may be greater than a level of stress applied to the battery based on the voltage cycle 921. As another example, the level of stress applied to the battery by the illustrated large or big cycle, e.g., as one of the types of voltage cycles, may be greater than the level of stress applied to the battery by the illustrated small cycle, e.g., as another one of the types of voltage cycles. As demonstrated in FIG. 9, and only as an example, such big or small cycles may be distinguished based on the degree or extent of the charging and/or discharging, e.g., with the small cycle of voltage cycle 921 being over a range of 0.2V and the big (or large) cycle of voltage cycle 911 being over a range of 0.5V and/or with the small cycle of voltage curve 921 being over a range of 100 seconds and the big cycle of voltage cycle 911 being over a range of 20,000 seconds.

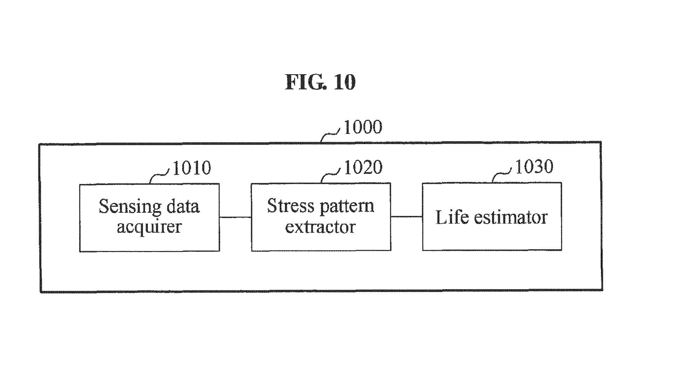

FIG. 10 illustrates an example of a battery life estimation apparatus 1000, according to one or more embodiments.

Referring to FIG. 10, the battery life estimation apparatus 1000 may include a sensing data acquirer 1010, a stress pattern extractor 1020, and a life estimator 1030, for example.

The battery life estimation apparatus 1000 may estimate a state of a battery (for example, an SOH), e.g., as an energy source in an EV embodiment of the present disclosure. For example, the battery life estimation apparatus 1000 may provide more exact state information of EVs to drivers of the EVs by more accurately estimating an SOH, and accordingly drivers may have a more positive opinion about EVs such as they do for gasoline powered vehicles. Additionally, depending on embodiment, the battery life estimation apparatus 1000 may be lighter in weight compared to previous estimation systems, and may even be mounted in a battery management system (BMS), such as a BMS in an EV embodiment of the present disclosure. Furthermore, depending on embodiment, the battery life estimation apparatus 1000 may be applicable to all physical applications employing batteries, in addition to EVs.

The sensing data acquirer 1010 may acquire sensing data of the battery. The sensing data may include, for example, at least one of voltage data, current data, and temperature data. In an embodiment, the sensing data acquirer 1010 may be a system that also includes such sensors. For example, the voltage data, the current data, and the temperature data may be respectively acquired from one or more voltage sensors, current sensors, and temperature sensors that may be configured to sense such physical characteristics or properties of the battery. Also, the sensing data may include data acquired from additional or alternative sensors, for example, a pressure sensor and a humidity sensor, in addition to any, or any combination, of the voltage sensor, the current sensor, and the temperature sensor. The sensing data acquirer 1010 may be a system that also includes such additional or alternative sensors. As only an example, the sensing data may refer to time-series data sensed during a predetermined time interval. For example, the voltage sensor may sense a voltage of the battery for "10" seconds (sec), e.g., based on a control signal or flag of the sensing data acquirer 1010, and the sensing data acquirer 1010 may acquire that sensed data for that predetermined time interval from the voltage sensor.

In such an example, the sensing data acquirer 1010 may routinely or periodically update such sensing data. For example, when an update period of "24" hours is set, the sensing data acquirer 1010 may acquire sensing data every "24" hours from a sensor that is configured to sense a characteristic of the battery. The update period may be set in advance, or set variably by an external apparatus, as only examples. The external apparatus refers to apparatuses other than the battery life estimation apparatus 1000.

In another example, the sensing data acquirer 1010 may acquire such sensing data based on a control signal received from the external apparatus. For example, in response to a control signal from the external apparatus instructing the battery life estimation apparatus 1000 to estimate the battery life, the sensing data acquirer 1010 may receive or obtain sensing data from a sensor configured to sense one or more characteristics of the battery.

The stress pattern extractor 1020 may extract a stress pattern from the obtained sensing data. As noted above, stress refers to the damage on the battery caused by charging and discharging of the battery, or another action that damages the battery. The stress pattern refers to a pattern in which a state of the battery changes based on stress applied to the battery.

The stress may be applied to the battery by charging and discharging of the battery and accordingly, a life of the battery may be reduced. When stress is applied to the battery, the state of the battery, for example a voltage, a current, or a temperature of the battery, may change. The stress pattern extractor 1020 may thus extract a stress pattern of the battery from the sensing data. For example, the voltage of the battery may increase when the battery is charged and may decrease when the battery is discharged. In this example, the voltage of the battery may change based on the level of the applied stress and thus, the stress pattern extractor 1020 may extract or interpret a voltage cycle based on charging and discharging of the battery as a stress pattern.

As only an example, the stress pattern extractor 1020 may extract the stress pattern from the sensing data using a rainflow counting scheme. The stress pattern may include a plurality of cycles representing changes in values of the differing sensing data. The plurality of extracted or interpreted cycles may be the "full cycle" or "half cycle" discussed above. Thus, the full cycle is a cycle of an increase and decrease in a value of the sensing data over time, and the half cycle is a cycle of either an increase or a decrease in a value of the sensing data over time.

In an example, the stress pattern extractor 1020 may apply the rainflow counting scheme to any of voltage data, current data, or pressure data of the battery, sensed or measured during a predetermined period of time, to extract an example stress pattern. In another example, the stress pattern extractor 1020 may apply the rainflow counting scheme to another sensing data representing the state of the battery other than the voltage data, the current data, and the pressure data, to extract an example stress pattern. In still another example, to extract a stress pattern from the sensing data, the stress pattern extractor 1020 may use other schemes of extracting the stress pattern, in addition or alternatively to the rainflow counting scheme.

Thus, the stress pattern extractor 1020 generates characteristic data representing a characteristic of the stress pattern(s). Herein, characteristic data may refer to categorized data obtained by quantifying a stress pattern. The characteristic data may be, for example, in the form of a histogram.

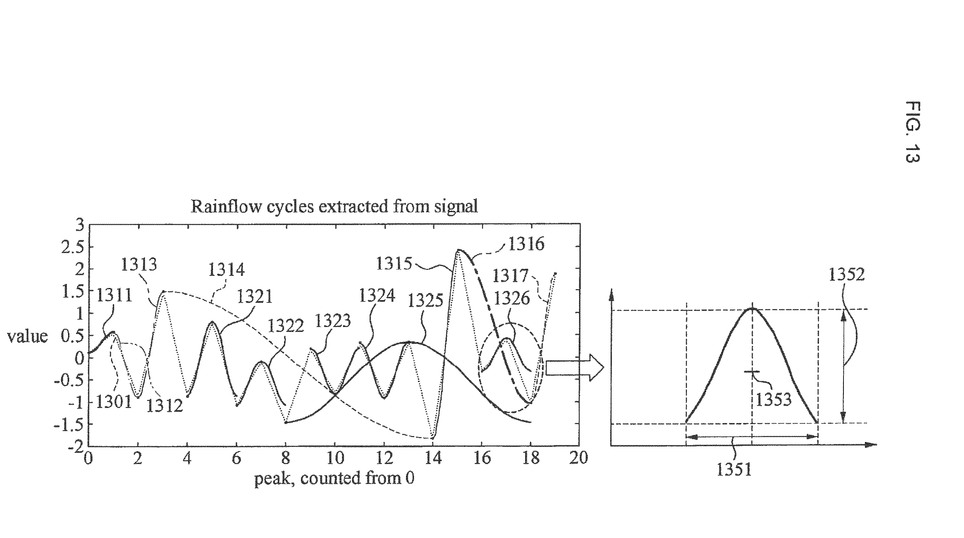

For example, the stress pattern extractor 1020 may extract a level corresponding to each of the plurality of cycles from a plurality of levels of respective predetermined parameters, and generate the characteristic data based on the extracted level. The predetermined parameter may include, for example, at least one of an offset, an amplitude, and a period of each of the plurality of cycles, such as illustrated in the right graph of FIG. 13 with the illustrated cycle's offset 1353, amplitude 1352, and period 1351. The offset indicates a position or size of a cycle, and may be, for example, a mean value or a median value of the cycle. Additionally, the stress pattern extractor 1020 may calculate a number of cycles corresponding to each of the plurality of levels among the plurality of cycles and generate the characteristic data based on the number of cycles.

For example, the stress pattern extractor 1020 may divide or categorize an amplitude of a cycle into four level ranges or categories. When a stress pattern includes ten cycles, and the ten cycles have amplitudes of "1.5," "1.7," "2.1," "2.5," "3.2," "3.6," "3.8," "4.3," "4.5," and "4.6," respectively, the stress pattern extractor 1020 may calculate that two cycles correspond to a first range with an amplitude of "1" to "2," that two cycles correspond to a second range with an amplitude of "2" to "3," that three cycles correspond to a third range with an amplitude of "3" to "4," and that three cycles correspond to a fourth range with an amplitude of "4" to "5." Thus, the stress pattern extractor 1020 may generate bins respectively corresponding to the first through the fourth ranges, and may generate a histogram, such as a histogram in which each of bins corresponding to the first range and the second range has a size of "2" and each of bins corresponding to the third range and the fourth range has a size of "3."

In an example, when a plurality of parameters are used for each extracted cycle, the stress pattern extractor 1020 may create a plurality of combination parameters by combining a plurality of levels of the plurality of parameters, may calculate a number of cycles corresponding to each of the plurality of combination parameters among the plurality of cycles, and may generate the characteristic data. A combination parameter may include or represent a respective level or range for each of the parameters represented by the combination parameter. There may also be such a combination parameter for each extracted cycle. In this example, the stress pattern extractor 1020 may calculate the number of cycles using a weight based on an extracted or interpreted cycle pattern of the plurality of cycles. For example, when an offset, an amplitude, and a period are determined in advance as parameters, and when the stress pattern extractor 1020 divides each of the offset, the amplitude, and the period into three level ranges or categories, the stress pattern extractor 1020 may combine one of three level ranges of the offset, one of three level ranges of the amplitude, and one of three level ranges of the period, to create 27 bins, i.e., $3^3$ bins, that each represent one of three level ranges of the offset, one of three level ranges of the amplitude, and one of three level ranges of the period. The stress pattern extractor 1020 may calculate a number of cycles that correspond to or match each of the 27 bins. As only an example, the stress pattern extractor 1020 may also set a weight to an interpreted half cycle differently from a weight set an interpreted full cycle, and may calculate the number of cycles based on the set weights. For example, when the stress pattern extractor 1020 sets the weight of half cycles to "0.5" and sets the weight of full cycles to "1," when a single half cycle and two full cycles correspond to a first bin, and when five half cycles and a single full cycle correspond to a second bin, the stress pattern extractor 1020 may set or determine the number of cycles that correspond to or match the first bin and the number of cycles that correspond to or match the second bin to be "2.5" and "3.5," respectively. Accordingly, the stress pattern extractor 1020 may generate a histogram based on such a determined number of cycles corresponding to each bin.

In another example, the stress pattern extractor 1020 may generate the characteristic data based on a predetermined period, and may generate a single piece of characteristic data by accumulating extracted characteristic data over multiple predetermined periods. For example, when the stress pattern extractor 1020 extracts a stress pattern from sensing data acquired for "60,000" seconds, with an extraction period of "30,000" seconds, the stress pattern extractor 1020 may extract first characteristic data from sensing data acquired during a period of "0" seconds to "30,000" seconds and may extract second characteristic data from sensing data acquired during a period of "30,000" seconds to "60,000" seconds, and then accumulate the first characteristic data and the second characteristic data, and generate a single piece of characteristic data.

In an embodiment, the stress pattern extractor 1020 may represent the characteristic data as a vector.

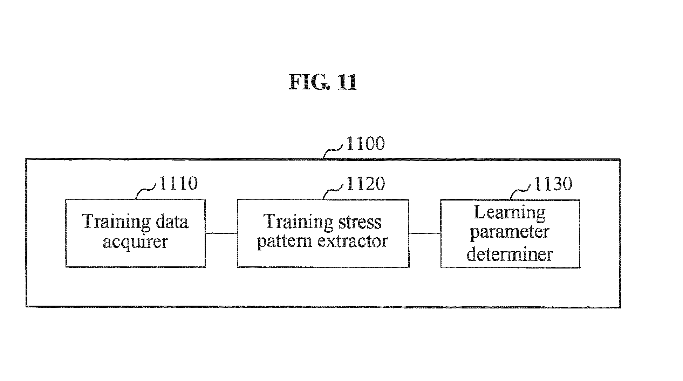

The life estimator 1030 may estimate the life of the battery based on the extracted stress pattern. In an embodiment, the life estimator 1030 may input characteristic data representing a characteristic of the stress pattern to a predetermined learner, and may estimate the life of the battery. As only an example, the life estimator 1030 may input, to the predetermined learner, characteristic data extracted from voltage data, or three pieces of characteristic data extracted from each of voltage data, current data, and temperature data. With the learner, when an input and output , the learner may have been caused to learn a parameter to generate an output corresponding to the input, such as discussed below with regard to FIG. 11. For real time life estimating, current or real time characteristic data may be input to the learner that has been provided the learned parameter, also referred to as a learning parameter. The learner may be a leaner using one of a neural network (NN) model, a support vector regression model, and a Gaussian process regression model, as only examples, as, the learner may use an alternative learning model capable of estimating a life of a battery based on a stress pattern.

Thus, to more accurately estimate the life of the battery, the life estimator 1030 may apply a predetermined learning parameter to a predetermined learner. In an example, when the predetermined learner is the NN model predetermined learner, the predetermined learning parameter may include activation functions, a weight, and a connection pattern between neurons. In another example, when the predetermined learner is the support vector regression model predetermined learner, the predetermined learning parameter may include a kernel function and a penalty parameter. In still another example, when the predetermined learner is the Gaussian process regression model predetermined learner, the predetermined learning parameter may include a kernel function and a hyperparameter.

In an embodiment, the life estimator 1030 may receive such a learning parameter from an external apparatus (for example, a preprocessing apparatus) using a communication interface, and input the received learning parameter to the predetermined learner. The external apparatus may include, for example, apparatuses other than the battery life estimation apparatus 1000. In the following description, the communication interface may include, as only an example, a wireless Internet interface and a local area communication interface. The wireless Internet interface may include, as only an example, a wireless local area network (WLAN) interface, a wireless fidelity (Wi-Fi) Direct interface, a Digital Living Network Alliance (DLNA) interface, a Wireless Broadband (WiBro) interface, a World Interoperability for Microwave Access (WiMAX) interface, a High Speed Downlink Packet Access (HSDPA) interface, and other interfaces known to one of ordinary skill in the art. The local area communication interface may include, as only an example, a Bluetooth interface, a radio frequency identification (RFID) interface, an Infrared Data Association (IrDA) interface, a Ultra Wideband (UWB) interface, a ZigBee interface, a near field communication (NFC) interface, and other interfaces known to one of ordinary skill in the art. In addition, the communication interface may include, for example, all interfaces (for example, a wired interface) communicable with the external apparatus. Depending on embodiment, the communication interface may also, or alternatively, be used for alternate communications and sharing of information operations.

In an example, the battery life estimation apparatus 1000 includes a storage configured to store in advance the predetermined learning parameter. In this example, the life estimator 1030 may extract the learning parameter from the storage and apply the extracted learning parameter to the predetermined learner. Also, the life estimator 1030 may learn, or have learned, a parameter based on various stress patterns and may extract the learning parameter, as discussed below with regard to FIG. 11.

In another example, the battery life estimation apparatus 1000 may include a dimension transformer configured to reduce a dimension of the characteristic data. For example, the dimension transformer may reduce the dimension of the characteristic data using a principal component analysis (PCA) or a linear discriminant analysis (LDA), both of which may minimize the loss of information during the dimension reduction. The life estimator 1030 may input the characteristic data with the reduced dimension to the predetermined learner, which may estimate the life of the battery based on the reduced dimension characteristic data. By inputting the characteristic data with the reduced dimension to the predetermined learner, a time required for the life estimator 1030 to estimate the life of the battery may be reduced.

In an example, when characteristic data is input to a learner, the learner may output a remaining capacity of a battery. The life estimator 1030 may extract battery life information from the output remaining capacity. The battery life information may be calculated using the below Equation 3, for example.

Equation 3:

$$SoH = \frac{C_e}{C_1}$$

In Equation 3, SoH denotes the battery life information, $C_1$ denotes a capacity of the battery at a time of manufacturing of the battery, for example, and $C_e$ denotes the output remaining capacity of the battery. For example, when the capacities $C_1$ and $C_e$ are set to 50 kilowatt hour (kWh) and 40 kWh, respectively, the life estimator 1030 may calculate a life of the battery to be 80%.

FIG. 11 illustrates an example of a battery life estimation apparatus 1100, according to one or more embodiments.

Referring to FIG. 11, the battery life estimation apparatus 1100 may include a training data acquirer 1110, a training stress pattern extractor 1120, and a learning parameter determiner 1130, for example.

The battery life estimation apparatus 1100 may determine a learning parameter in order to estimate a life of a battery. For example, the battery life estimation apparatus 1100 may perform a preprocessing process of the battery life estimation apparatus 1000 of FIG. 10 to estimate the life of the battery. For example, in an embodiment, the battery life estimation apparatus 1000 of FIG. 10 may include such a training data acquirer, training stress pattern extractor, and learning parameter determiner as a preprocessor, in addition to a sensing data acquirer, stress pattern extractor, and life estimator, with potentially the sensing data acquirer and the training data acquirer being the same sensor acquiring device or system.

The training data acquirer 1110 may acquire training data of the battery. The training data may include, for example, any, or any combination, of voltage data, current data, and temperature data of a battery. Also, the training data may include additional data representing a state of such a battery (for example, pressure data and humidity data). The training data acquirer 1110 may acquire training data of a single battery or training data of a plurality of batteries or battery cells. Additionally, the training data acquirer 1110 may acquire training data from a predetermined database or an external apparatus. For example, the training data acquirer 1110 may update the training data from the predetermined database or the external apparatus based on an update period, or may acquire the training data from the predetermined database or the external apparatus based on a control signal received from the external apparatus.

The training stress pattern extractor 1120 may extract a training stress pattern from the training data. The training stress pattern refers to a pattern in which a state of a battery, from which training data is sensed, changes based on stress applied to the battery. In an example, the training stress pattern extractor 1120 may use a rainflow counting scheme to extract the training stress pattern from the training data. In this example, the training stress pattern may include a plurality of cycles representing changes in values of the training data over time. The plurality of cycles may be a full cycle or a half cycle. The training stress pattern extractor 1120 may use other extracting schemes to extract the training stress pattern from the training data, in addition or alternatively to the rainflow counting scheme.

The training stress pattern extractor 1120 may extract a level corresponding to each of a plurality of cycles among a plurality of levels of respective predetermined parameters, and generate characteristic data based on a number of cycles corresponding to each of the plurality of levels among the plurality of cycles. As noted above, characteristic data may refer to categorized data obtained by quantifying a stress pattern(s). The predetermined parameter may include, as only an example, any, or any combination, of an offset, an amplitude, and a period of each of the plurality of cycles. Similar to the stress pattern extractor 1020 of FIG. 10, training stress pattern extractor 1120 may calculate the number of cycles using a weight based on a cycle pattern of the plurality of cycles. For example, the training stress pattern extractor 1120 may set a weight of an interpreted half cycle and a weight of an interpreted full cycle to "0.5" and "1," respectively, and may calculate a single half cycle and a single full cycle as "0.5" and "1," respectively.

For example, the training stress pattern extractor 1120 may divide a parameter into a plurality of level ranges or categories, and may generate a bin corresponding to each of the level ranges. The training stress pattern extractor 1120 may calculate a number of cycles that correspond to each of the plurality of levels, and may set or determine a size of a bin, for a predetermined level range, to be the number of cycles corresponding to the predetermined level range. The training stress pattern extractor 1120 may generate a histogram including bins as characteristic data.

When a plurality of parameters are used for an extracted or interpreted cycle, the training stress pattern extractor 1120 may create a plurality of combination parameters by combining a plurality of levels or ranges of the plurality of parameters, may calculate a number of cycles that correspond to each of the plurality of combination parameters among the plurality of cycles, and may generate the characteristic data. Each of the combination parameters may include or represent levels or ranges for each of plural parameters. The training stress pattern extractor 1120 may generate a plurality of bins corresponding to each of the plurality of combination parameters, may set or determine a size of a bin, for a predetermined combination parameter, to be the number of cycles that correspond to or match the predetermined combination parameter, and may generate a histogram based on the same. The training stress pattern extractor 1120 may represent the characteristic data as a vector. In an example, the training stress pattern extractor 1120 may also reduce a dimension of the characteristic data using a PCA or an LDA.

The learning parameter determiner 1130 may determine a learning parameter based on the training stress pattern. The learning parameter may then be used to estimate the life of the battery. The learning parameter determiner 1130 may extract the learning parameter by inputting characteristic data representing a characteristic of the training stress pattern to a predetermined learner. As noted, in an embodiment, characteristic data may be represented in the form of a vector. The predetermined learner may learn, based on the characteristic data, such a learning parameter optimized for a learning model of the predetermined learner. For example, the predetermined learner may use any, or any combination, of an NN model, a support vector regression model, and a Gaussian process regression model. In an example, when the predetermined learner is the NN model predetermined learner, the determined learning parameter may include activation functions, a weight, and a connection pattern between neurons. In another example, when the predetermined learner is a support vector regression model predetermined learner, the determined learning parameter may include a kernel function and a penalty parameter. In still another example, when the predetermined learner is a Gaussian process regression model predetermined learner, the determined learning parameter may include a kernel function and a hyperparameter. The predetermined learner may use another learning model capable of estimating the life of the battery based on the characteristic data, in addition to or instead of using the NN model, the support vector regression model, and/or the Gaussian process regression model. The learning parameter determined by the learning parameter determiner 1130 may be used when the battery life estimation apparatus 1100 estimates the life of the battery. For example, the life estimator 1030 of FIG. 10 may use the learning parameter when estimating the life of the battery based on current or real-time data, for example, sensed by the sensing data acquirer 1010.

In an example, the battery life estimation apparatus 1100 may include a storage, and the learning parameter determiner 1130 may store the determined learning parameter in the storage. Additionally, the learning parameter determiner 1130 may transmit the determined learning parameter to an external apparatus using a communication interface. As another example, the battery life estimation apparatus 1000 of FIG. 10 may include storage that stores the determined learning parameter, e.g., stored by the learning parameter determiner 1130 or stored upon receipt from the communication interface of the battery life estimation apparatus 1100.

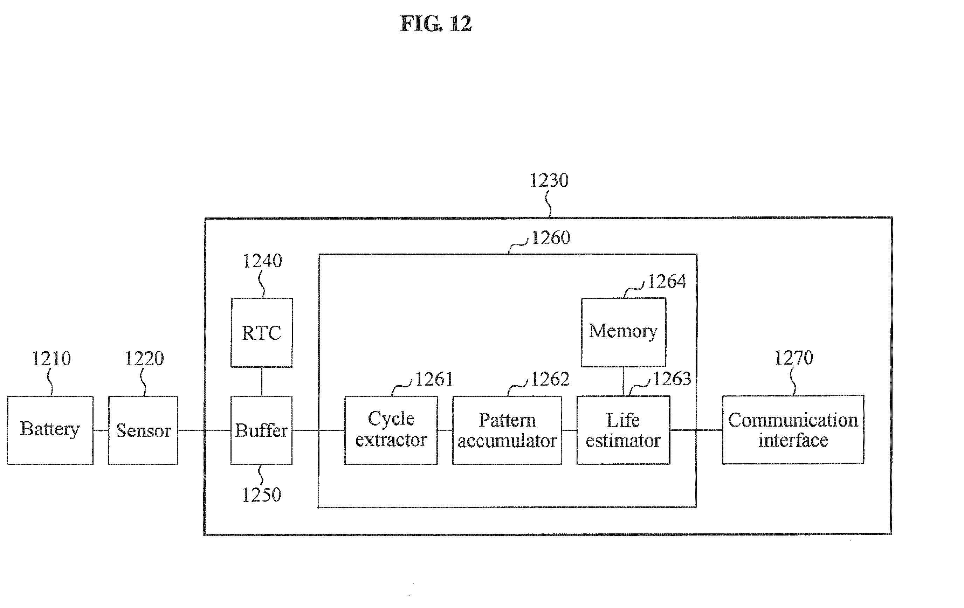

FIG. 12 illustrates an example of a battery system, according to one or more embodiments.

Referring to FIG. 12, the battery system may include a battery 1210, a sensor 1220, and a battery control apparatus 1230. In FIG. 12, the sensor 1220 may be located outside the battery control apparatus 1230, or may be located in the battery control apparatus 1230, depending on embodiment.

In an embodiment, the battery 1210 supplies power to a driving vehicle embodiment of the present disclosure that includes the battery 1210. The battery 1210 may include a plurality of battery modules. Capacities of the plurality of battery modules may be the same as or different from each other.

The sensor 1220 may acquire sensing data of the battery 1210. In the illustrated battery system of FIG. 12, the sensor 1220 is phrased as being a single sensor, however, sensor 1220 may include a plurality of sensors, and may further represent a system of sensors. The sensor 1220 may include, for example, any, or any combination, of a voltage sensor, a current sensor, and a temperature sensor. For example, the sensor 1220 may measure in real time at least one of voltage data, current data, and temperature data of the plurality of battery modules in the battery 1210.

The battery control apparatus 1230 may include a real-time clock (RTC) 1240, a buffer 1250, a battery life estimation apparatus 1260, and a communication interface 1270, for example.

The buffer 1250 may store the sensing data of the battery 1210 obtained or received from the sensor 1220.

The RTC 1240 may keep a current time, for example. The battery life estimation apparatus 1260 may record, using the RTC 1240, a point in time at which the sensing data is received from the sensor 1220.

The battery life estimation apparatus 1260 may include a cycle extractor 1261, a pattern accumulator 1262, a life estimator 1263, and a memory 1264, for example.

The cycle extractor 1261 may extract a plurality of cycles representing a stress pattern from the sensing data stored in the buffer 1250, e.g., using a rainflow counting scheme. The plurality of cycles represent changes in values of the sensing data over time.

The pattern accumulator 1262 may generate characteristic data by quantifying the plurality of cycles. For example, the generated characteristic data may be represented in the form of a histogram. The pattern accumulator 1262 may extract a level corresponding to each of the plurality of cycles from among a plurality of levels of a predetermined parameter, and generate the characteristic data based on the extracted level. The predetermined parameter may be, as only examples, any, or any combination, of an offset, an amplitude, and a period of each of the plurality of cycles. The pattern accumulator 1262 may calculate a number of cycles corresponding to each of the plurality of levels among the plurality of cycles, and generate the characteristic data based on the number of cycles. The pattern accumulator 1262 may calculate the number of cycles using differing weights based on different extracted or interpreted cycle patterns of the plurality of cycles. Additionally, the pattern accumulator 1262 may divide the predetermined parameter into a plurality of level ranges or categories, and may generate a bin corresponding to each of the level ranges. The pattern accumulator 1262 may set or determine a size of a bin, for a predetermined level range, to be the number of cycles that correspond to or match the predetermined level range, and may generate a histogram including bins as characteristic data.

When a plurality of parameters are used for each extracted or interpreted cycle, the pattern accumulator 1262 may create a plurality of combination parameters by combining a plurality of levels or ranges of the plurality of parameters, may calculate the number of cycles whose parameters correspond to or match each of the plurality of combination parameters among the plurality of cycles, and may generate the characteristic data. A combination parameter may represent plural levels or ranges for each of the parameter of the combination parameter.

The pattern accumulator 1262 may generate a plurality of bins respectively corresponding to each of the plurality of combination parameters, may set or determine a size of a bin for a predetermined combination parameter to be the number of cycles whose parameters correspond to or match the predetermined combination parameter, and may generate a histogram. For example, the pattern accumulator 1262 may represent the characteristic data as a vector. In an example, the pattern accumulator 1262 may reduce a dimension of the characteristic data using a PCA or an LDA. In another example, the pattern accumulator 1262 may generate characteristic data based on multiple predetermined periods, may accumulate extracted characteristic data over the multiple predetermined periods, and may generate a single piece of characteristic data from the accumulated extracted characteristic data.

The life estimator 1263 estimates the life of the battery based on the corresponding stress pattern represented by the characteristic data. Thus, the life estimator 1263 may input characteristic data representing a characteristic of the stress pattern to a predetermined learner, and may estimate the life of the battery. For example, with the predetermined learner, when an input and output are given, the learner may be, or have been, caused to learn a learning parameter to generate an output corresponding to the input. The learner may use, for example, one of an NN model, a support vector regression model, and a Gaussian process regression model.

Additionally, the life estimator 1263 may apply a predetermined learning parameter stored in the memory 1264 to the predetermined learner. For example, when the NN model is implemented by the predetermined learner, the life estimator 1263 may extract an activation function stored in the memory 1264, and may apply the activation function to the predetermined learner.

The life estimator 1263 may transmit information on the estimated life of the battery to an external apparatus (for example, an electronic control unit (ECU) of a vehicle embodiment) via the communication interface 1270.

FIG. 13 illustrates an example of a stress pattern, according to one or more embodiments.

Referring to FIG. 13, the left graph shows a plurality of cycles representing a stress pattern of a battery. In the left graph, the horizontal axis represents time or an order in which full or half cycles are extracted from sensing data and the vertical axis represents a value of a cycle.

A battery life estimation apparatus extracts or interprets a plurality of cycles from sensing data, e.g., using a rainflow counting scheme. In the left graph, the battery life estimation apparatus extracts or interprets cycles from voltage data 1301, which may include half cycles 1311 through 1317 and full cycles 1321 through 1326. As explained above, a full cycle refers to charging and discharging or a discharging and a charging sequence of the battery, while differently a half cycle may be a charging or discharging sequence. For example, full cycle 1321 includes a charging and discharging of the battery and full cycle 1323 includes a discharging and charging of the battery, while half cycle 1311 may include only a charging of the battery and half cycle 1312 may include only a discharging of the battery.

The right graph of FIG. 13 shows a zoomed-in view of the full cycle 1326. In the right graph, the horizontal axis represents time and the vertical axis represents a value of a cycle, e.g., a value of the voltage when the cycle is a voltage cycle.

In the right graph, the battery life estimation apparatus may determine or set a period 1351, an amplitude 1352, and an offset 1353 (for example, a median value) as parameters of the full cycle 1326. Thus, the battery life estimation apparatus may extract the period 1351, the amplitude 1352, and the offset 1353, combine a level of each of the period 1351, the amplitude 1352, and the offset 1353, and generate characteristic data of the full cycle 1326.

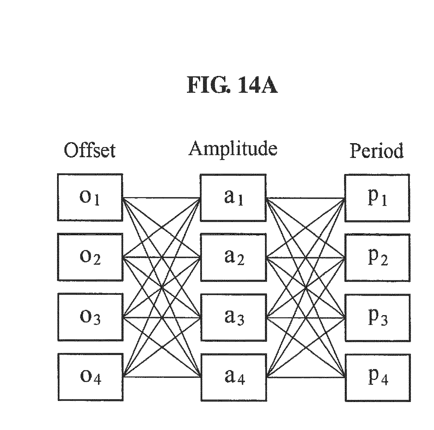

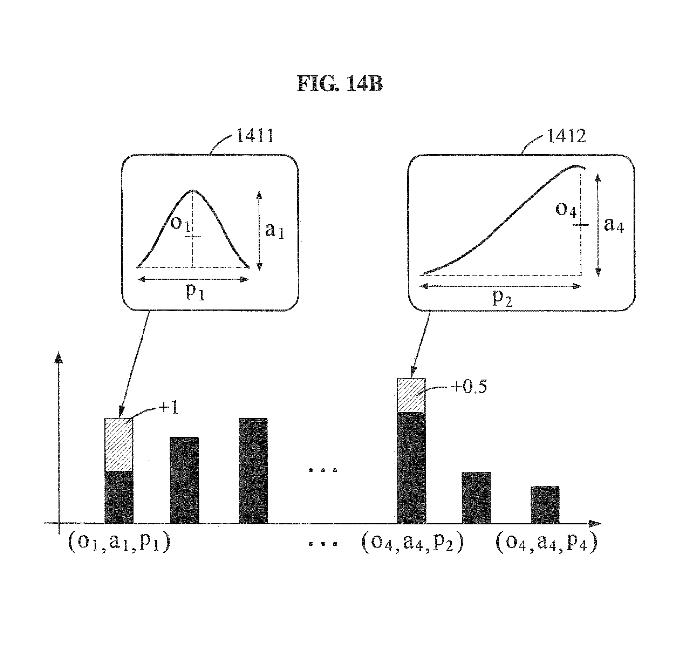

FIGS. 14A and 14B illustrate an example of characteristic data generation, according to one or more embodiments.

FIG. 14A illustrates an example of a combination of an offset, an amplitude, and a period of multiple cycles. A battery life estimation apparatus may extract characteristic data from sensing data of a battery. The battery life estimation apparatus may extract a plurality of cycles from the sensing data and may determine or set an offset, an amplitude, and a period as a parameter for each of the cycles. The battery life estimation apparatus may divide each of the offset, the amplitude, and the period into four level ranges or categories. The battery life estimation apparatus may create combination parameters by combining level ranges of the offset, level ranges of the amplitude, and level ranges of the period. Each of the combination parameters may include one of the level ranges of the offset, one of the level ranges of the amplitude, and one of the level ranges of the period, such that any of the extracted cycles can be characterized by one of the combination parameters. For example, in FIG. 14A, the battery life estimation apparatus creates 64 combination parameters, i.e., $4^3$ combination parameters, for example, combination parameters $(o_1, a_1, p_1)$, $(o_1, a_1, p_2)$, and $(o_1, a_1, p_3)$, respectively for extracted cycles that have offsets and amplitudes of the same ranges but different periods ranges of p1, p2, and p3.

FIG. 14B illustrates an example of characteristic data based on the combination parameters of FIG. 14A. In FIG. 14B, the characteristic data is expressed by a histogram. In a graph of FIG. 14B, the horizontal axis represents the combination parameters and the vertical axis represents the number of cycles whose parameters correspond to or match the respective combination parameters. In the histogram, each of the combination parameters is represented as a bin.

The battery life estimation apparatus calculates a number of cycles whose parameters correspond to or match each of 64 bins, i.e., $4^3$ bins. The battery life estimation apparatus calculates the number of cycles by setting a weight for the full cycle 1411 to be different from a weight set for the half cycle 1412. For example, when the weight of the full cycle 1411 and the weight of the half cycle 1412 are set to "1" and "0.5," respectively, the battery life estimation apparatus may calculate a number of the full cycles 1411 as "1," and calculate a number of half cycles 1412 as "0.5."

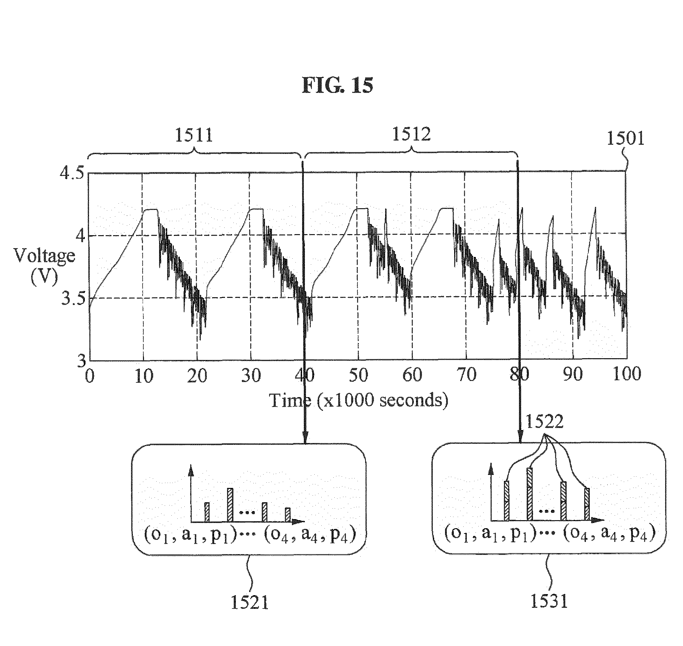

FIG. 15 illustrates an example of characteristic data generation, according to one or more embodiments.

The graph 1501 of FIG. 15 shows voltage data of a battery. In the graph 1501, the horizontal axis represents time and the vertical axis represents a voltage level.

A battery life estimation apparatus may generate characteristic data based on voltage data, e.g., every predetermined period. For example, in FIG. 15, the characteristic data is represented by a histogram, and the battery life estimation apparatus sets a generation period (or predetermined period) of the characteristic data to be "40,000" seconds. The battery life estimation apparatus may generate characteristic data 1521 based on voltage data 1511 sensed during a period of time of "0" seconds to "40,000" seconds. Additionally, the battery life estimation apparatus may generate characteristic data 1522 based on voltage data 1512 sensed during a period of time of "40,000" seconds to "80,000" seconds. Here, the battery life estimation apparatus may further generate characteristic data 1531 by accumulating the characteristic data 1522 with the characteristic data 1521. The battery life estimation apparatus estimates a life of the battery by inputting the characteristic data 1531 to a predetermined learner.

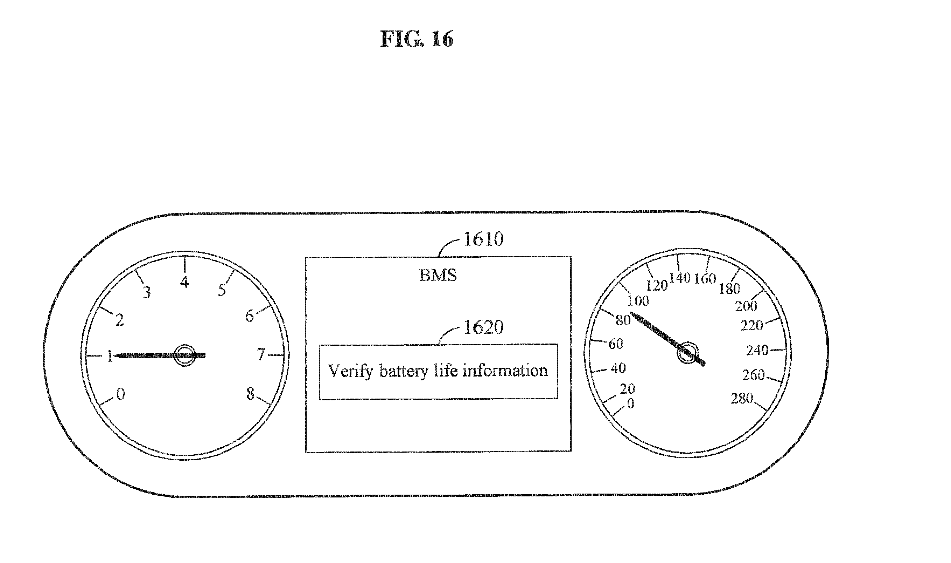

FIG. 16 illustrates an example of a user interface, according to one or more embodiments.

Referring to FIG. 16, a battery control apparatus, such as the battery control apparatus 1230 of FIG. 12, may receive a trigger signal from an external apparatus, and estimate a life of a battery in response to a reception of the trigger signal. Accordingly, the battery control apparatus may estimate the life of the battery in real time. For example, when an ignition of an EV embodiment including the battery and the battery control apparatus is turned on, an ECU of the EV embodiment may display a user interface 1610 on a dashboard. The user interface 1610 may include an interface 1620 configured to generate a trigger signal. For example, when a user selects the interface 1620, the ECU may transmit a trigger signal to the battery control apparatus, such as the battery control apparatus 1230 of FIG. 12, to estimate the life of the battery, and then the user interface 1610 may display the resultant estimated life of the battery indicated by the battery control apparatus. The battery control apparatus may acquire sensing data of the battery, may extract, from the sensing data, a stress pattern representing changes in states of the battery based on stresses applied to the battery, and may estimate the life of the battery based on the stress pattern.

The battery control apparatus may transmit the estimated life of the battery to the ECU, for example, and the ECU may control the user interface 1610 to display the life of the battery received from the battery control apparatus.

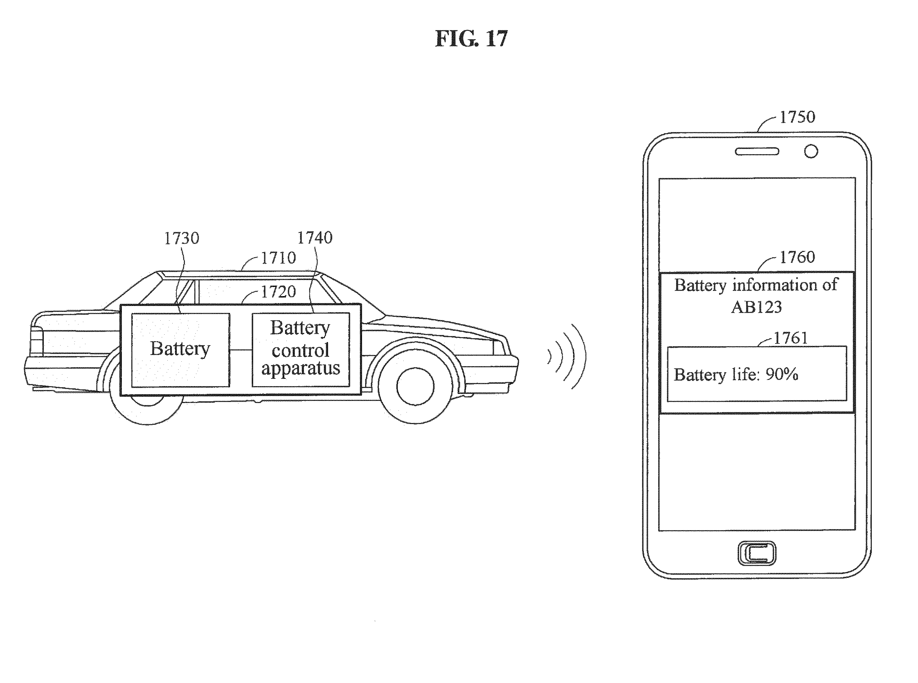

FIG. 17 illustrates an example of a user interface to provide battery life information, according to one or more embodiments.

Referring to FIG. 17, an EV 1710 embodiment may include a battery system 1720, which may include a battery 1730, and a battery control apparatus 1740. The battery control apparatus may operate similarly to the battery control apparatus of FIG. 12, as only an example. The battery control apparatus 1740 may estimate a life of the battery 1730 and transmit the life of the battery 1730 to a terminal 1750 using a wireless interface, for example. The EV 1710 may also, or alternatively, include the user interface 1610 of FIG. 16 and accordingly display the life of the battery 1730 to a user of the EV 1710.

In addition to the above example of FIG. 16 and interaction of the user interface 1610, in an example, the battery control apparatus 1740 may receive a trigger signal from the terminal 1750 via the wireless interface, and may estimate the life of the battery 1730 in response to a reception of the trigger signal. The battery control apparatus 1740 may transmit the estimated life to the terminal 1750 using the wireless interface. The terminal 1750 may then display a life 1761 of the battery 1730 using a user interface 1760. Accordingly, an embodiment further includes the terminal 1750 that is configured to transmit the trigger signal to such an EV 1710 to control such a battery control apparatus 1740 and configured to display the estimated life of the battery as received from the EV 1710 and recognized by the terminal 1750.

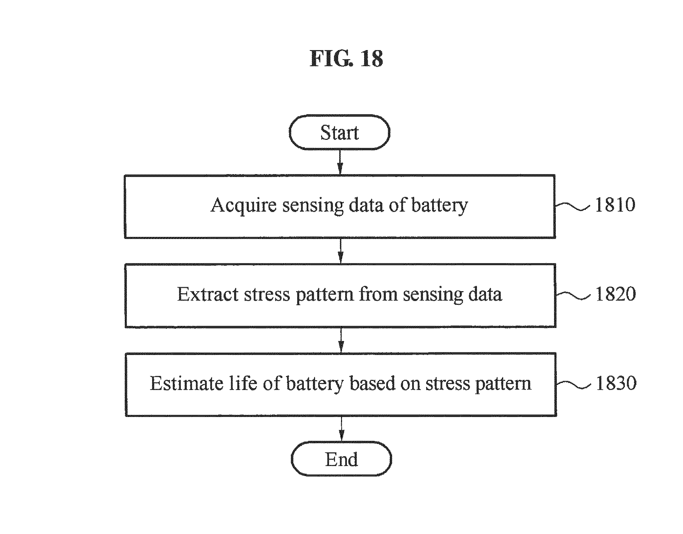

FIG. 18 illustrates an example of a battery life estimation method, according to one or more embodiments.

Referring to FIG. 18, in operation 1810, sensing data of a battery may be obtained or acquired. As only an example, any of the battery estimation apparatuses or systems described above may acquire the described sensing data, extract a corresponding stress pattern, and estimate a battery life based on the same, without limiting the below method description to the same.

In operation 1820, a stress pattern may be extracted from the sensing data. The stress pattern refers to a pattern in which states of the battery change based on stresses applied to the battery.

In operation 1830, a life of the battery may be estimated based on the extracted stress pattern.

As noted, the above disclosures regarding FIGS. 1 through 17 are equally applicable to embodiments of the battery life estimation method of FIG. 18 and accordingly, will not be repeated here.

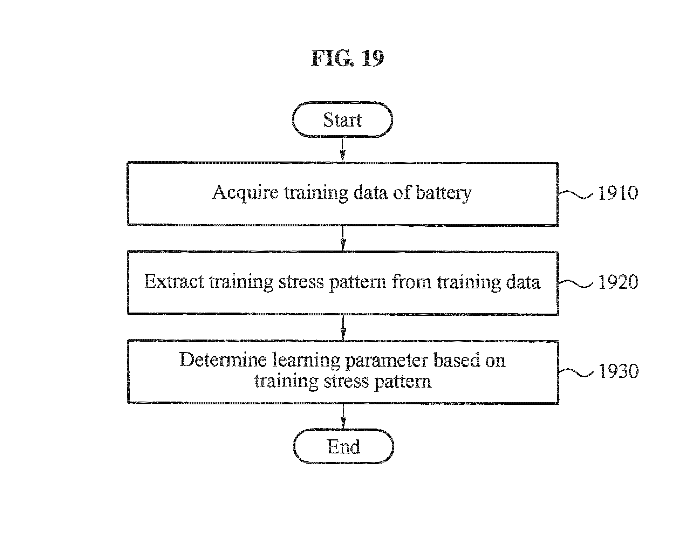

FIG. 19 illustrates an example of a battery life estimation method, according to one or more embodiments.

Referring to FIG. 19, in operation 1910, training data of a battery may be acquired. As only an example, any of the battery estimation apparatuses or systems described above may acquire the described training data, extract a corresponding training stress pattern, and determine a learning parameter based on the same, without limiting the below method description to the same.

In operation 1920, a training stress pattern may be extracted from the training data. The training stress pattern refers to a pattern in which states of a battery, from which training data is sensed or determined, change based on stresses applied to the battery.

In operation 1930, a learning parameter may be determined based on the training stress pattern. The learning parameter is used to estimate a life of the battery.

In addition, as explained above, operations 1910 through 1930 may be performed in combination operations 1810 through 1830 of FIG. 18, e.g., as a preprocessing operation to determine a learning parameter that may be used in operation 1830 to estimate a life of the battery in real time.

As noted, the above disclosures regarding FIGS. 1 through 17 are equally applicable to embodiments of the battery life estimation method of FIG. 19 and accordingly, will not be repeated here.

The apparatuses, units, modules, devices, and other components illustrated in FIGS. 10, 11, 12, 16, and 17, for example, that may perform operations described herein with respect to FIGS. 9, 13-15, and 18-19, for example, are implemented by hardware components. Examples of hardware components include controllers, sensors, memory, drivers, and any other electronic components known to one of ordinary skill in the art. In one example, the hardware components are implemented by one or more processing devices, or processors, or computers. A processing device, processor, or computer is implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices known to one of ordinary skill in the art that is capable of responding to and executing instructions in a defined manner to achieve a desired result. In one example, a processing device, processor, or computer includes, or is connected to, one or more memories storing instructions or software that are executed by the processing device, processor, or computer and that may control the processing device, processor, or computer to implement one or more methods described herein. Hardware components implemented by a processing device, processor, or computer execute instructions or software, such as an operating system (OS) and one or more software applications that run on the OS, to perform the operations described herein with respect to FIGS. 9, 13-15, and 18-19, as only an example. The hardware components also access, manipulate, process, create, and store data in response to execution of the instructions or software. For simplicity, the singular term "processing device", "processor", or "computer" may be used in the description of the examples described herein, but in other examples multiple processing devices, processors, or computers are used, or a processing device, processor, or computer includes multiple processing elements, or multiple types of processing elements, or both. In one example, a hardware component includes multiple processors, and in another example, a hardware component includes a processor and a controller. A hardware component has any one or more of different processing configurations, examples of which include a single processor, independent processors, parallel processors, remote processing environments, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 9, 13-15, and 18-19 that perform the operations described herein may be performed by a processing device, processor, or a computer as described above executing instructions or software to perform the operations described herein.

Instructions or software to control a processing device, processor, or computer to implement the hardware components and perform the methods as described above may be written as computer programs, code segments, instructions or any combination thereof, for individually or collectively instructing or configuring the processing device, processor, or computer to operate as a machine or special-purpose computer to perform the operations performed by the hardware components and the methods as described above. In one example, the instructions or software include machine code that is directly executed by the processing device, processor, or computer, such as machine code produced by a compiler. In another example, the instructions or software include higher-level code that is executed by the processing device, processor, or computer using an interpreter. Based on the disclosure herein, and after an understanding of the same, programmers of ordinary skill in the art can readily write the instructions or software based on the block diagrams and the flow charts illustrated in the drawings and the corresponding descriptions in the specification, which disclose algorithms for performing the operations performed by the hardware components and the methods as described above.

The instructions or software to control a processing device, processor, or computer to implement the hardware components, such as discussed in any of FIGS. 10, 11, 12, 16, and 17, and perform the methods as described above in any of FIGS. 9, 13-15, and 18-19, and any associated data, data files, and data structures, are recorded, stored, or fixed in or on one or more non-transitory computer-readable storage media. Examples of a non-transitory computer-readable storage medium include read-only memory (ROM), random-access memory (RAM), flash memory, CD-ROMs, CD-Rs, CD+Rs, CD-RWs, CD+RWs, DVD-ROMs, DVD-Rs, DVD+Rs, DVD-RWs, DVD+RWs, DVD-RAMs, BD-ROMs, BD-Rs, BD-R LTHs, BD-REs, magnetic tapes, floppy disks, magneto-optical data storage devices, optical data storage devices, hard disks, solid-state disks, and any device known to one of ordinary skill in the art that is capable of storing the instructions or software and any associated data, data files, and data structures in a non-transitory manner and providing the instructions or software and any associated data, data files, and data structures to a processing device, processor, or computer so that the processing device, processor, or computer can execute the instructions. In one example, the instructions or software and any associated data, data files, and data structures are distributed over network-coupled computer systems so that the instructions and software and any associated data, data files, and data structures are stored, accessed, and executed in a distributed fashion by the processing device, processor, or computer.

As a non-exhaustive example only, an electronic device embodiment herein, e.g., that includes an apparatus estimating a state of a battery, as described herein, may be a vehicle, a mobile device, such as a cellular phone, a smart phone, a wearable smart device, a portable personal computer (PC) (such as a laptop, a notebook, a subnotebook, a netbook, or an ultra-mobile PC (UMPC), a tablet PC (tablet), a phablet, a personal digital assistant (PDA), a digital camera, a portable game console, an MP3 player, a portable/personal multimedia player (PMP), a handheld e-book, a global positioning system (GPS) navigation device, or a sensor, or a stationary device, such as a desktop PC, a high-definition television (HDTV), a DVD player, a Blu-ray player, a set-top box, or a home appliance, or any other mobile or stationary device capable of wireless or network communication.

While this disclosure includes specific examples, it will be apparent to one of ordinary skill in the art that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is not limited by the detailed description, but further supported by the claims.

**Claims**

1. A battery life estimation apparatus comprising:

   a stress pattern extractor configured to use at least one processing device to extract a stress pattern from sensing data acquired for a battery, the stress pattern representing changes in states of the battery based on stresses applied to the battery and **characterized by** categorizing different stresses represented in the sensing data; and
   a life estimator configured to use at least one processing device to estimate a life of the battery based on the characterized stress pattern.

2. The battery life estimation apparatus of claim 1, further comprising a sensor system including a plurality of sensors to measure the sensing data of the battery, the sensing data being real time measurements of physical properties of the battery.

3. The battery life estimation apparatus of claim 1 or 2, wherein the life estimator estimates the life of the battery in real time by providing characteristic data, as the categorized different stresses, to a learner to which a learning parameter is applied, wherein the learning parameter is previously trained on battery training sensing data of a previous time, and/or the life estimation apparatus further comprising:

   a training data acquirer configured to acquire the battery training sensing data for the battery, in the previous time;
   a training stress pattern extractor configured to use at least one processing device to extract a training stress pattern from the battery training sensing data, the training stress pattern representing changes in states of the battery based on stresses applied to the battery and **characterized by** categorizing different stresses represented in the training data; and
   a learning parameter determiner configured to use at least one processing device to determine the learning parameter based on the characterized training stress pattern.

4. The battery life estimation apparatus of one of claims 1 to 3, wherein the sensing data comprises at least one of voltage data, current data, and temperature data of the battery sensed from respective sensors configured to measure corresponding properties of the battery, and/or
   wherein the stress pattern extractor is configured to extract the stress pattern from the sensing data using a rainflow counting scheme, and
   wherein the stress pattern represents a plurality of cycles that respectively represent changes in values of the sensing data over time, and/or
   wherein the stress pattern extractor is configured to perform the categorizing by extracting a level for each of the plurality of cycles from a plurality of levels of a determined parameter, and configured to generate, based on each of the levels, characteristic data representing a characteristic of the stress pattern.

5. The battery life estimation apparatus of claim 4, wherein the stress pattern extractor is configured to perform the categorizing by generating the characteristic data based on a determined number of cycles, of the plurality of cycles, that correspond to each of the plurality of levels, or
   wherein the stress pattern extractor is configured to create a plurality of combination parameters, each representing respective levels for each of a plurality of the determined parameters for a cycle, and configured to perform the categorizing by generating the characteristic data based on a determined number of cycles, of the plurality of cycles, whose determined parameters correspond to each of the plurality of combination parameters, or
wherein the stress pattern extractor is configured to generate the characteristic data at a predetermined period, so that characteristic data is generated for plural predetermined periods.

6. The battery life estimation apparatus of claim 5, wherein the stress pattern extractor is configured to determine the number of cycles by applying different weights to different cycle patterns of the plurality of cycles, or
further comprising a dimension transformer configured to reduce a dimension of the characteristic data,
wherein the life estimator is configured to estimate the life of the battery by inputting the characteristic data with the reduced dimension to a predetermined learner to which a predetermined learning parameter is applied.

7. The battery life estimation apparatus of claim 6, wherein the different cycle patterns include full and half cycle patterns.

8. The battery life estimation apparatus of claim 5, wherein the life estimator is configured to estimate the life of the battery by inputting the characteristic data to a predetermined learner to which a predetermined learning parameter is applied, or
wherein the determined parameter comprises at least one of an offset, an amplitude, and a period of each of the plurality of cycles.

9. The battery life estimation apparatus of claim 8, further comprising a dimension transformer configured to reduce a dimension of the characteristic data, wherein the life estimator is configured to estimate the life of the battery by inputting the characteristic data with the reduced dimension to the predetermined learner, or
further comprising a communication interface, wherein the life estimator is configured to receive the predetermined learning parameter from an external apparatus using the communication interface, and configured to apply the received learning parameter to the predetermined learner, or
further comprising a storage configured to store in advance the predetermined learning parameter,
wherein the life estimator is configured to obtain the predetermined learning parameter from the storage and apply the obtained predetermined learning parameter to the predetermined learner.

10. A battery life estimation method comprising:

    acquiring training data for physical properties for a battery;
    extracting, using at least one processing device, a training stress pattern from the training data, the training stress pattern representing changes in states of the battery based on stresses applied to the battery and **characterized by** categorizing different stresses represented by the training data; and
    determining, using at least one processing device, a learning parameter based on the characterized training stress pattern, the learning parameter being determined for use in estimating a life of the battery.

11. The method of claim 10, wherein the training data is derived from a previous measuring of physical properties of the battery, or
further comprising extracting the training stress pattern from the training data using a rainflow counting scheme, and wherein the training stress pattern represents a plurality of cycles that respectively represent changes in values of the training data over time.

12. The method of claim 10, further comprising categorizing by extracting a level for each of the plurality of cycles from a plurality of levels of a determined parameter, and generating characteristic data based on a determined number of cycles, of the plurality of cycles, that correspond to each of the plurality of levels, so that the characteristic data represents a characteristic of the training stress pattern. or
wherein determining the parameter comprises at least one of an offset, an amplitude, and a period of each of the plurality of cycles, or
further comprising creating a plurality of combination parameters, each representing respective levels for each of a plurality of the determined parameters for a cycle, and categorizing by generating the characteristic data based on a determined number of cycles, of the plurality of cycles, whose determined parameters correspond to each of the plurality of combination parameters, or
further comprising extracting the learning parameter by inputting the characteristic data to a predetermined learner.

13. The method of claim 12, further comprising the step of transmitting the extracted learning parameter to an external apparatus using the communication interface, and/or
storing the extracted learning parameter in a storage.

14. A non-transitory computer-readable storage medium comprising computer readable code to cause at least one processing device to perform the method of estimating a battery life, comprising the steps of:

acquiring sensing data for physical properties of a battery;
generating, using at least one processing device, characterization data that categorizes different stresses of a battery from the acquired sensing data of the battery; and
estimating and outputting, using at least one processing device, a life of the battery based on the characterization data.

15. The non-transitory computer-readable medium of claim 14, further comprising measuring, by a sensor system including a plurality of sensors, the sensing data of the battery, the sensing data being real time measurements of physical properties of the battery, or
estimating the life of the battery in real time by providing the characteristic data to a learner to which a learning parameter is applied, wherein the learning parameter is previously trained on battery training sensing data of a previous time.

## FIG. 1

FIG. 2

# FIG. 3

**FIG. 4**

**FIG. 5**

## FIG. 6

FIG. 7

## FIG. 8

FIG. 9

EP 3 048 451 A1

**FIG. 10**

1000

| 1010 | 1020 | 1030 |
|------|------|------|
| Sensing data acquirer | Stress pattern extractor | Life estimator |

**FIG. 11**

1100

| 1110 | 1120 | 1130 |
| Training data acquirer | Training stress pattern extractor | Learning parameter determiner |

**FIG. 12**

EP 3 048 451 A1

FIG. 13

Rainflow cycles extracted from signal

## FIG. 14A

Offset    Amplitude    Period

$o_1$    $a_1$    $p_1$

$o_2$    $a_2$    $p_2$

$o_3$    $a_3$    $p_3$

$o_4$    $a_4$    $p_4$

## FIG. 14B

FIG. 15

FIG. 16

# FIG. 17

EP 3 048 451 A1

## FIG. 18

Start

Acquire sensing data of battery 1810

Extract stress pattern from sensing data 1820

Estimate life of battery based on stress pattern 1830

End

# FIG. 19

Start

Acquire training data of battery   ~1910

Extract training stress pattern from training data   ~1920

Determine learning parameter based on training stress pattern   ~1930

End

Europäisches
Patentamt

European
Patent Office

Office européen
des brevets

# EUROPEAN SEARCH REPORT

Application Number

EP 15 19 3812

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NUHIC ADNAN ET AL: "Health diagnosis and remaining useful life prognostics of lithium-ion batteries using data-driven methods", JOURNAL OF POWER SOURCES, ELSEVIER SA, CH, vol. 239, 13 December 2012 (2012-12-13), pages 680-688, XP028566893, ISSN: 0378-7753, DOI: 10.1016/J.JPOWSOUR.2012.11.146 * figures 2,3 * * chapter 1 * * chapter 2.2 * * chapter 3 * * chapter 4.1 * | 1-15 | INV. G01R31/36 |
| X | WO 2012/166489 A2 (CATERPILLAR INC [US]; MIDDLETON JUSTIN DALE [US]; TREICHEL BENJAMIN AR) 6 December 2012 (2012-12-06) | 1,2,4, 14,15 | |
| A | * figures 1B,2,3A-C,5 * * page 10, line 10 - page 12, line 2 * * page 13, line 17 - page 19, line 25 * * page 22, line 15 - page 24, line 19 * | 3,6-13 | |
| X | WO 2009/035288 A2 (LG CHEMICAL LTD [KR]; SONG HYUN-KON [KR]; CHO JEONG-JU [KR]; CHOO YEON) 19 March 2009 (2009-03-19) | 1-4, 10-15 | TECHNICAL FIELDS SEARCHED (IPC) |
| A | * figures 1-8 * * paragraph [0031] - paragraph [0046] * * paragraph [0060] * * paragraph [0066] - paragraph [0076] * * paragraph [0081] - paragraph [0105] * | 5-9 | G01R |

The present search report has been drawn up for all claims

| Place of search | Date of completion of the search | Examiner |
|---|---|---|
| Munich | 9 June 2016 | Nguyen, Minh |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 19 3812

This annex lists the patent family members relating to the patent documents cited in the above-mentioned European search report.
The members are as contained in the European Patent Office EDP file on
The European Patent Office is in no way liable for these particulars which are merely given for the purpose of information.

09-06-2016

| Patent document cited in search report | | | Publication date | Patent family member(s) | | | Publication date |
|---|---|---|---|---|---|---|---|
| WO 2012166489 | A2 | | 06-12-2012 | US | 2012310561 | A1 | 06-12-2012 |
| | | | | WO | 2012166489 | A2 | 06-12-2012 |
| WO 2009035288 | A2 | | 19-03-2009 | CN | 101803104 | A | 11-08-2010 |
| | | | | EP | 2206191 | A2 | 14-07-2010 |
| | | | | JP | 5313250 | B2 | 09-10-2013 |
| | | | | JP | 2010539473 | A | 16-12-2010 |
| | | | | KR | 20090020448 | A | 26-02-2009 |
| | | | | US | 2010312733 | A1 | 09-12-2010 |
| | | | | WO | 2009035288 | A2 | 19-03-2009 |

EPO FORM P0459

For more details about this annex : see Official Journal of the European Patent Office, No. 12/82